# FASCICULE DE BREVET EUROPEEN

(11) **EP 0 688 462 B1**
(45) Date de publication et mention de la délivrance du brevet: **27.11.1996**
(21) Numéro de dépôt: 94909166.4
(22) Date de dépôt: 08.03.1994
(51) Int. Cl.: G01R 33/38, H01F 7/02

(54) **STRUCTURE D'AIMANT PERMANENT A HAUTE EFFICACITE ET A FAIBLES FUITES**
DAUERMAGNETANORDNUNG MIT HOHER EFFEKTIVITÄT UND MIT NIEDRIGER STREUUNG
HIGH EFFICIENCY, LOW LEAKAGE PERMANENT MAGNET

(30) Priorité: 09.03.1993 FR 9302700
(43) Date de publication de la demande: 27.12.1995
(73) Titulaire: COMMISSARIAT A L'ENERGIE ATOMIQUE, 75752 Paris Cédex 15 (FR)
(72) Inventeur: LOCATELLI, Marcel, F-38330 Montbonnot (FR); CHAILLOUT, Jean-Jacques, F-38960 Saint-Etienne-de-Crossey (FR)
(74) Mandataire: Dubois-Chabert, Guy
(86) Numéro de dépôt international: FR9400257
(87) Numéro de publication internationale: WO9420971

(56) Documents cités:
- EP-A- 0 161 782
- EP-A- 0 170 318
- US-A- 4 816 796

## Description

La présente invention se rapporte d'une manière générale aux aimants permanents qui permettent de produire une induction homogène dans un volume donné et qui trouvent leurs applications industrielles, par exemple, dans l'imagerie par résonance magnétique.

L'imagerie par résonance magnétique (IRM) tend à devenir une technique très répandue dans les milieux médicaux, ce qui fait que les exigences d'installation et d'exploitation deviennent de plus en plus contraignantes, notamment par exemple en ce qui concerne le poids des installations, les champs de fuite des aimants et les problèmes de maintenance et d'investissement.

Les techniques connues de réalisation d'aimants permanents consistent toujours à insérer dans un circuit magnétique des aimants proprement dits qui constituent les forces magnétomotrices du système. Le circuit magnétique de l'aimant peut comporter entre autre deux plaques planes et parallèles qui constituent l'entrefer et délimitent la cavité dans laquelle sont introduits les matériaux ou les être vivants que l'on désire soumettre à une induction magnétique donnée comme c'est le cas notamment dans l'imagerie par résonance magnétique. Cet espace libre dans l'entrefer comporte en général un volume d'accès proprement dit et au centre de la structure un volume utile à l'intérieur duquel l'induction magnétique est suffisamment homogène pour les besoins de l'expérimentation recherchée.

Le problème technique que cherche toujours à résoudre les fabriquants de tels aimants permanents est celui de l'optimisation de la structure et la recherche des valeurs du champ démagnétisant de l'induction dans le matériau constituant les sources magnétomotrices correspondent aux valeurs optimales pour lesquelles l'énergie magnétique provenant du matériau constituant les sources magnétomotrices utilisées est maximale. L'homme du métier sait d'ailleurs déterminer ce point d'efficacité maximum de chaque matériau, pour lesquels la courbe de désaimantation est tangente à la courbe d'isoénergie.

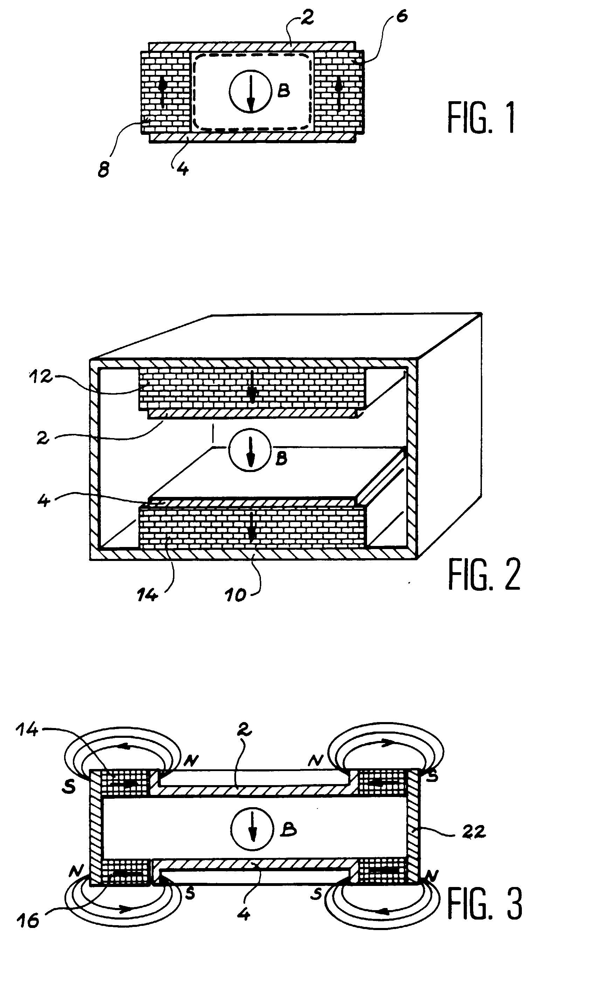

Jusqu'à ce jour, des structures d'aimants permanents connues ont été réalisées à partir de trois formes différentes essentielles que l'on a représentées sur les figures 1 à 3 ci-jointes et que l'on décrira à nouveau pour bien fixer les idées.

La figure 1 représente la structure connue sous le nom de structure de Watson qui comporte comme on le voit sur la figure, deux pièces polaires 2 et 4 constituées de plaques magnétiques, se faisant face entretoisées à leurs extrémités par deux aimants 6 et 8 ayant des polarités de même sens. Sur la figure les flèches montrent la direction de l'induction dans les différents matériaux ainsi que dans le volume utile de l'entrefer.

Sur la figure 2, on a représenté la structure dite en **H** ; elle comporte comme on le voit une culasse magnétique 10 parallélépipédique, sur les deux parois horizontales de laquelle sont fixés respectivement deux aimants 12 et 14 ayant des polarités de même orientation. Les pièces polaires de l'entrefer sont référencées 2 et 4 et l'induction B dans cet entrefer est représenté par une flèche.

Enfin, la figure 3 montre, en coupe diamétrale, la structure qui comporte cette fois les deux pièces polaires 2 et 4 toujours face à face ainsi que deux aimants annulaires référencés 14 et 16 à aimantation radiale. Les aimants 14 et 16 sont sur les faces opposées de la paroi cylindrique 22 qui maintient les aimants à égale distance l'un de l'autre. Chaque aimant est maintenu en contact direct avec sa pièce polaire 2 ou 4 par des épanouissements de celle-ci. Comme on le voit d'après le sens des flèches marquées sur la figure, les aimantations des aimants 14 et 16 sont de sens opposés. Cette dernière structure est décrite notamment dans le brevet américain US-A-4 816 796 du 29 Mars 1989. Elle a le grave inconvénient de donner lieu à d'importantes fuites magnétiques comme indiqué par les lignes de champ autour des aimants 14 et 16 de la figure 3.

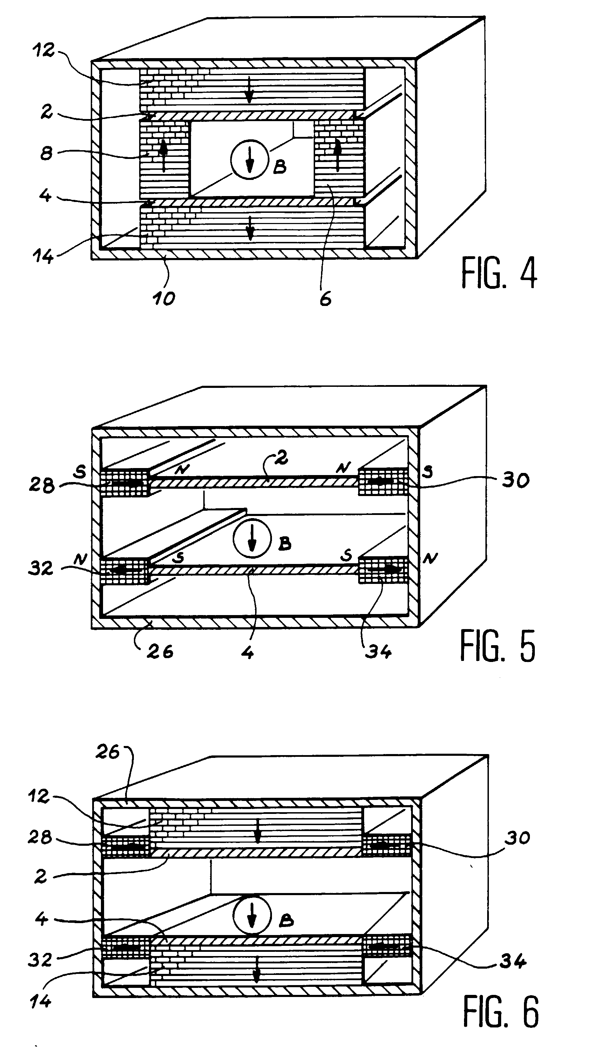

Dans certains cas mêmes, des structures d'aimants ont été réalisées en associant les formes connues précédentes pour obtenir une amélioration de l'efficacité des matériaux. C'est le cas par exemple de la structure décrite dans le brevet français FR-A-87.028.51 du 03 Mars 1987 qui est une structure du type Watson+H décrite de manière schématique sur la figure 4. On retrouve en effet sur cette figure les éléments correspondants à l'addition de ceux des figures 1 et 2. Cette solution permet d'obtenir des inductions plus importantes qu'avec une structure unique "H" ou "Watson" à partir d'un matériau donné existant, si l'on adopte comme critère l'efficacité maximale des matériaux en vue de réduire les masses et les coûts.

D'une manière générale, les aimants permanents actuellement connus sont réalisés à partir de matériaux tels que le ferrite dur ou le néodyme fer-bore dont l'efficacité dépend de la géométrie, du champ démagnétisant et de l'induction auxquels ils sont soumis. Si l'on veut par conséquent augmenter encore l'efficacité des aimants utilisés, c'est par recours à l'action sur l'une de ces trois grandeurs qu'il faut s'attacher. Malheureusement, les modifications de configuration sont relativement difficiles ou limitées, du fait de la difficulté pour donner une estimation de l'induction en tout point de la structure, en particulier liée à la maîtrise des fuites magnétiques. Cette l'estimation nécessite le recours à des méthodes mathématiques spécifiques et compliquées. Pour les configurations, les dimensions minimales des pièces polaires sont imposées par la valeur de l'homogénéité du champ que l'on souhaite obtenir et par les volumes d'accès et utiles de l'entrefer. Par ailleurs, la nécessité de limiter les fuites magnétiques des structures conduit à utiliser des aimants permanents qui doivent déborder des pièces polaires comme on le voit par exemple sur les figures 1, 2 et 4 qui décrivent l'art connu. Ce dernier phénomène impose pratiquement les dimensions latérales des aimants permanents des structures "H" ou "Watson".

De ce fait, les possibilités d'optimisation d'une structure d'aimants permanents sont principalement limitées à la recherche d'un matériau magnétique présentant des bonnes valeurs de champ démagnétisant et d'induction et comme de tels matériaux sont au nombre limité, la recherche de l'optimum n'est pas toujours possible.

La présente invention a précisément pour objet une structure d'aimant permanent à haute efficacité magnétique et à faible fuite qui permet toutes choses égales par ailleurs, une meilleurs optimisation de la structure que les solutions de l'art connu que l'on vient de rappeler.

Cette structure d'aimant permanent à haute efficacité magnétique et à faibles fuites, notamment pour installations de résonance magnétique nucléaire, de disposition générale parallélépipédique, comportant deux plaques planes et horizontales perméables magnetiquement et disposées en regard l'une de l'autre pour constituer l'entrefer de la structure, quatre aimants parallélépipédiques destinés à produire une induction magnétique homogène dans l'entrefer, une culasse de fermeture de circuit magnétique, les aimants, la culasse et les plaques étant reliés pour constituer un circuit magnétique fermé à l'exception de l'entrefer, caractérisée en ce que chaque aimant est en forme de lame parallélépipédique allongée, la culasse étant parallélépipédique et chacun desdits aimants, disposés parallèlement entre eux, assurant une liaison entre un côté d'une plaque et une paroi latérale et adjacente de la culasse, les deux aimants d'une même plaque étant au contact de cette plaque par leurs pôles de polarité identique et étant chacun au contact d'une paroi de la culasse par leur autres pôles, cette disposition des polarités étant inversée d'une plaque à l'autre, la culasse comportant en outre des prolongements assurant la liaison entre les pôles des aimants d'une même plaque qui sont en contact avec lesdites parois.

C'est comme on le voit la présence d'une carcasse fermée sur elle-même et continue qui, en permettant la réduction maximale des champs de fuite, confère à cette structure son originalité et son efficacité. Selon une caractéristique intéressante de la présente invention, la culasse de la structure d'aimant permanent précédente est prolongée par des épanouissements ou diaphragmes sur les faces avant et/ou arrière de l'entrefer pour minimiser les fuites dans une direction perpendiculaire à l'induction recherchée, c'est-à-dire dans la direction de l'axe du tunnel formant l'entrefer. Ces diaphragmes sont constitués par des épanouissements ou prolongation de la culasse dont la forme peut être adaptée à chaque cas particulier de façon à laisser un accès plus ou moins large à l'intérieur de la structure.

Enfin, selon une caractéristique essentielle de l'invention, celle-ci peut être avantageusement combinée avec des structures magnétomotrices du type en "H" ou du type en "W", voire avec la combinaison de la structure en "H" avec la structure en "W". On obtient par ces différentes combinaisons toute une série de structures qui offrent une panoplie complète et intéressante de solutions dans lesquelles l'homme du métier peut choisir en fonction de chaque cas particulier la réalisation la plus appropriée à ses objectifs.

Les aimants ou forces magnétomotrices insérés dans les différentes structures sont réalisés à partir de paralléléppipèdes en matériau dur (ferrite, néodyme fer-bore, terres rares) assemblés sous forme de colonnes par exemple par collage, puis aimantées. Celles-ci sont ensuite associées, par collage et frettage, pour constituer les différents aimants. La rigidité de la structure est assurée en particulier par les forces magnétiques, du fait de la présence des pièces polaires et de la carcasse lesquelles ne sont pas saturées magnétiquement, et par des liaisons par collage par exemple.

De toute façon l'invention sera mieux comprise en se référant à la description qui suit en se référant aux figures 5 à 9 ci-jointes, dans lesquelles :
- la figure 5 montre en coupe selon la largeur de l'entrefer, une structure d'aimant conforme à l'invention dite dans la suite du texte, "structure du type R" ;
- la figure 6 montre une structure du type "H" + "R" ;
- la figure 7 montre une structure du type "Watson" + "R"
- la figure 8a montre une structure du type "H"+"Watson"+"R" ;
- la figure 8b est une coupe de la figure 8a selon le plan vertical P repéré par yoz passant par le milieu de la structure suivant l'axe x ;
- les figures 9 et 10 montrent l'implantation sur la structure précédente des figures 8a et 8b d'épanouissements et de diaphragmes aux extrémités de la carcasse dans le plan YZ de la figure 8a.

Sur la figure 5 qui représente la structure dite de type "R" objet de l'invention, on retrouve les pièces polaires parallèles 2 et 4 de l'art antérieur montées cette fois dans une culasse fermée 26 aux parois supérieure et inférieure de laquelle elles se relient magnétiquement par les quatre aimants magnétomoteurs 28, 30, 32 et 34. Comme on le voit sur les dessins de la plaque supérieure 2, les aimants 28 et 30, sont de sens opposés, c'est-à-dire qu'ils tournent leur même polarité vers les extrémités de la plaque ; il en est de même pour les deux aimants inférieurs 32 et 34 qui sont jointifs à la pièce polaire 4 et ont également leur pôles face à face de même polarité, mais opposée à celle de la polarité des aimants 28 et 30. C'est ainsi que dans le schéma de la figure 5, le sens de l'induction étant donné par les flèches représentées, les deux aimants 28 et 30 opposent leur face Nord et les deux aimants 32 et 34 leur face Sud. On comprend sur cette figure, l'intérêt de cette structure qui, grâce aux parties supérieure et inférieure de sa carcasse 26 a le gros avantage par rapport à la structure connue de la figure 3, de supprimer les fuites de champ magnétique autour des quatre aimants 28, 30, 32 et 34.

Comme on l'a déjà expliqué précédemment, cette structure d'aimant permanent apporte en soi déjà un premier progrès non négligeable, mais il y a souvent lieu de la perfectionner encore en la combinant avec au moins l'une des structures connues du type en "H" ou du type "Watson".

C'est ainsi que la figure 6 montre avec les mêmes chiffres de référence une structure d'aimant permanent qui résulte de l'association de la structure en "R" précédente avec une structure en "H".

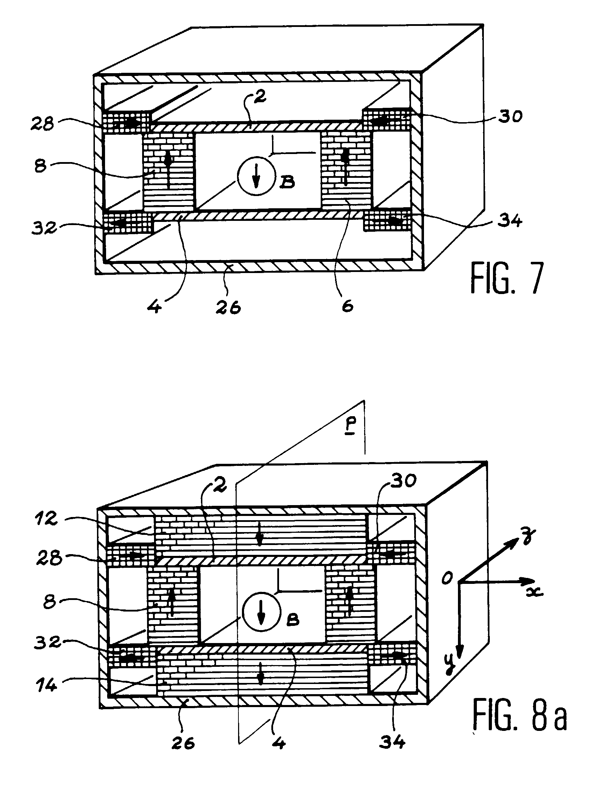

C'est ainsi que sur la figure 7 on a représenté une structure d'aimant permanent obtenue par combinaison de la structure objet de l'invention et d'une structure du type "W".

Sur la figure 8a enfin on a représenté la combinaison globale des trois structures "R", "H" et "Watson". Sur chaque figure, les sens des inductions magnétiques sont marquées par des flèches et les différents éléments portent les mêmes nombres de référence.

La structure "R" associée à une structure "H" ou à une structure "H" + "Watson" permet d'obtenir des valeurs d'induction élevées avec des masses plus faibles de matériau que dans le cas de la structure de départ. Par exemple pour une configuration à 0,2 Tesla, voir figure 8a, réalisée à partir de ferrite dur, le système "H" + "Watson" + "R" permet un gain de l'ordre de 5% par rapport à un système "H" + "Watson", soit 7,2 et 7,55 tonnes.

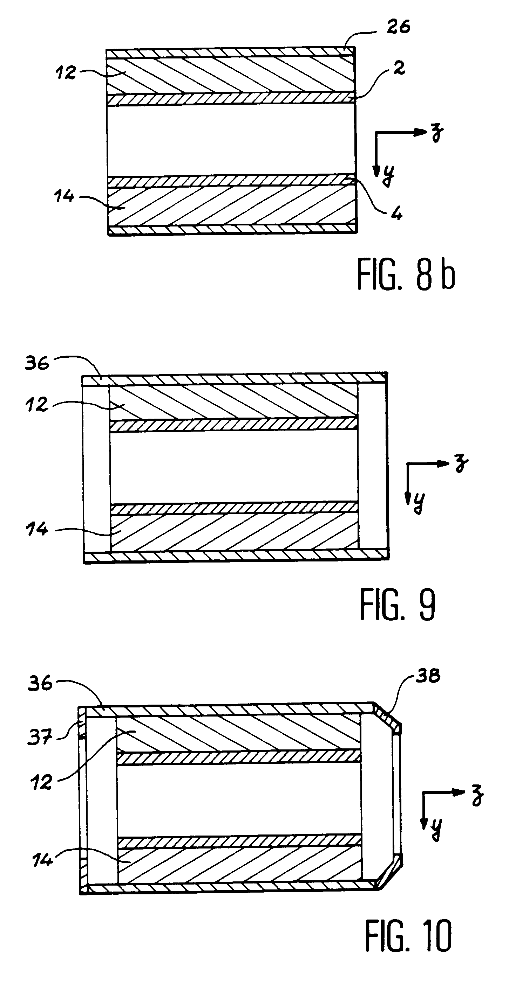

La figure 8b montre en coupe selon le plan vertical P de la figure 8a, la structure du type "R"+"H"+"Watson" avec une ouverture maximale, c'est-à-dire lorsque la carcasse est un parallèlèpipède de mêmes dimensions que les aimants permanents.

sur les figures 9 et 10, on a représenté dans le même plan p, YOZ de la figure 8a, deux variantes de réalisation de l'invention pour lesquelles la culasse est prolongée par des épanouissements 36 sur les faces avant et/ou arrière de l'entrefer. Ces épanouissements 36 peuvent supporter des diaphragmes 37 et 38 qui permettent d'obtenir pour l'entrefer des accès plus ou moins grands tout en diminuant

## Revendications

1. Structure d'aimant permanent à haute efficacité magnétique et à faibles fuites, notamment pour installations de résonance magnétique nucléaire, de disposition générale parallélépipédique, comportant deux plaques planes et horizontales perméables magnétiquement (2, 4) et disposées en regard l'une de l'autre pour constituer l'entrefer de la structure, quatre aimants parallélépipédiques (28, 30, 32, 34) destinés à produire une induction magnétique homogène dans l'entrefer, une culasse de fermeture de circuit magnétique (26), les aimants, la culasse et les plaques étant reliés pour constituer un circuit magnétique fermé à l'exception de l'entrefer, caractérisée en ce que chaque aimant est en forme de lame parallélépipédique allongée, la culasse étant parallélépipédique et chacun desdits aimants, disposés parallèlement entre eux, assurant une liaison entre un côté d'une plaque et une paroi latérale et adjacente de la culasse, les deux aimants d'une même plaque étant au contact de cette plaque par leurs pôles de polarité identique et étant chacun au contact d'une paroi de la culasse par leur autres pôles, cette disposition des polarités étant inversée d'une plaque à l'autre, la culasse comportant en outre des prolongements assurant la liaison entre les pôles des aimants d'une même plaque qui sont en contact avec lesdites parois.

2. Structure d'aimant permanent selon la revendication 1, caractérisée en ce que la culasse (26) est prolongée par des épanouissements (36) sur les faces avant et/ou arrière de l'entrefer.

3. Structure d'aimant permanent selon la revendication 2, caractérisée en ce que les épanouissements (36) supportent des diaphragmes (37, 38).

4. Structure d'aimant permanent selon la revendication 1, caractérisée en ce qu'elle comporte en outre une structure magnétomotrice dite en H, c'est-à-dire deux aimants (12, 14) orientés dans le même sens et situés respectivement dans les espaces libres entre les plaques constituant l'entrefer et la culasse.

5. Structure d'aimant permanent selon la revendication 1, caractérisée en ce qu'elle comporte en outre une structure magnétomotrice dite en W, c'est-à-dire deux aimants (6, 8) orientés dans le même sens situés entre les plaques constituant l'entrefer et aux extrémités de celles-ci.

6. Structure d'aimant permanent selon la revendication 1, caractérisée en ce qu'elle comporte en outre et à la fois une structure magnétomotrice en H et une structure magnétomotrice dite en W.

## Patentansprüche

1. Dauermagnetanordnung mit hoher Effizienz und niedriger Streuung, vor allem für Kernspinresonanzanlagen, mit im wesentlichen parallelflacher Anordnung, umfassend zwei ebene und horizontale Platten (2, 4), magnetisch permeabel und einander gegenüberstehend, um den Luftspalt der Anordnung zu bilden, vier parallelflache Magneten (28, 30, 32, 34), um eine homogene magnetische Induktion in dem Luftspalt zu erzeugen, ein Joch zum Schließen des Magnetkreises (26), wobei die Magneten, das Joch und die Platten verbunden sind, um mit Ausnahme des Luftspalts einen geschlossenen Magnetkreis zu bilden,
**dadurch gekennzeichnet,**
daß jeder Magnet die Form einer parallelflachen länglichen Lamelle aufweist, das Joch parallelflach ist und jeder der parallel zueinander angeordneten Magneten eine Verbindung sicherstellt zwischen einer Seite einer Platte und einer seitlichen und angrenzenden Wand des Jochs, die beiden Magneten von ein und derselben Platte durch ihre Pole identischer Polarität in Kontakt sind mit dieser Platte und jeder in Kontakt ist mit einer Wand des Jochs durch ihre anderen Pole, diese Anordnung der Polaritäten umgekehrt ist von einer Platte zur anderen, das Joch außerdem Verlängerungen umfaßt, die die Verbindung zwischen den Polen der Magneten derselben Platte sicherstellen, die mit besagten Wänden in Kontakt sind.

2. Dauermagnetanordnung nach Anspruch 1, dadurch gekennzeichnet, daß das Joch (26) verlängert wird durch Erweiterungen (36) an der Vorder- und/oder der Rückseite des Luftspalts.

3. Dauermagnetanordnung nach Anspruch 2, dadurch gekennzeichnet, daß die Erweiterungen (36) Blenden (37, 38) tragen.

4. Dauermagnetanordnung nach Anspruch 1, dadurch gekennzeichnet, daß sie außerdem eine magnetomotorische sogenannte H-Anordnung umfaßt, das heißt zwei Magneten (12, 14), die in dieselbe Richtung orientiert sind und sich jeweils in den freien Räumen zwischen den Platten befinden, die den Luftspalt und das Joch bilden.

5. Dauermagnetanordnung nach Anspruch 1, dadurch gekennzeichnet, daß sie außerdem eine magnetomotrische sogenannte W-Anordnung umfaßt, das heißt zwei in dieselbe Richtung orientierte Magneten (6, 8), angeordnet zwischen den den Luftspalt definierenden Platten und an deren Enden.

6. Dauermagnetanordnung nach Anspruch 1, dadurch gekennzeichnet, daß sie außerdem und gleichzeitig eine magnetomotorische H-Anordnung und eine magnetomotorische sogenannte W-Anordnung umfaßt.

## Claims

1. Permanent-magnet structure with high magnetic efficiency and with low leakage, especially for nuclear magnetic resonance installations, of general parallelepipedic arrangement, comprising two magnetically permeable plane and horizontal plates (2, 4) arranged opposite one another so as to form the flux gap of the structure, four parallelepipedic magnets (28, 30, 32, 34) intended to generate uniform magnetic induction in the flux gap, and a yoke (26) for closing the magnetic circuit, the magnets, yoke and plates being connected so as to form a closed magnetic circuit, with the exception of the flux gap, characterized in that each magnet is in the form of an elongate parallelepipedic strip, the yoke being parallelepipedic and each of the said magnets, arranged parallel to one another, making a connection between one side of a plate and an adjacent lateral wall of the yoke, the two magnets of the same plate being in contact with this plate via their poles of identical polarity and each being in contact with a wall of the yoke via their other poles, this arrangement of the polarities being reversed from one plate to the other, the yoke comprising, furthermore, extensions making the connection between the poles of the magnets of the same plate which are in contact with the said walls.

2. Permanent-magnet structure according to Claim 1, characterized in that the yoke (26) is extended by flared portions (36) on the front and/or rear faces of the flux gap.

3. Permanent-magnet structure according to Claim 2, characterized in that the flared portions (36) support diaphragms (37, 38).

4. Permanent-magnet structure according to Claim 1, characterized in that it comprises, furthermore, a so-called H-shaped magnetomotive structure, that is to say two magnets (12, 14) oriented in the same direction and located respectively in the free spaces between the plates forming the flux gap and the yoke.

5. Permanent-magnet structure according to Claim 1, characterized in that it comprises, furthermore, a so-called W-shaped magnetomotive structure, that is to say two magnets (6, 8) oriented in the same direction and located between the plates forming the flux gap and at the ends of these.

6. Permanent-magnet structure according to Claim 1, characterized in that it comprises, furthermore and at the same time, an H-shaped magnetomotive structure and a so-called W-shaped magnetomotive structure.
